(19)

Europäisches Patentamt

European Patent Office

Office européen des brevets

(11) **EP 2 747 292 A1**

(12) **EUROPEAN PATENT APPLICATION**

(43) Date of publication:
25.06.2014 Bulletin 2014/26

(21) Application number: **12306652.4**

(22) Date of filing: **21.12.2012**

(51) Int Cl.:
*H03M 13/29* (2006.01)          *H03M 13/11* (2006.01)
*H03M 13/37* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventors:
• **Schmalen, Laurent**
  **70435 Stuttgart (DE)**
• **Salsi, Massimiliano**
  **91620 Nozay (FR)**

(74) Representative: **Mildner, Volker et al**
**Alcatel-Lucent Deutschland AG**
**Intellectual Property & Standards**
**Lorenzstrasse 10**
**70435 Stuttgart (DE)**

(54) **Soft-decoding of concatenated error correction code for optical communications**

(57)     Proposed is a method of optical data transmission using a soft-decision error decoding scheme. An information word and a pre-defined bit-word are concatenated, yielding an extended information word. A code word is derived, by FEC encoding the extended information word, using a first systematic FEC encoding scheme. The resulting code word contains the provided information word, the pre-defined bit-word and the first parity word. A modified code word is derived, by FEC encoding the information word and the first parity word, using a second systematic FEC encoding scheme. The resulting modified code word contains the information word, a second parity word and the first parity word. This is due to the fact that the second FEC encoding scheme is a systematic encoding scheme. Finally, the modified code word is transmitted using a phase modulated optical signal. Further steps are carried out at the receiving side.

**Fig. 1a**

EP 2 747 292 A1

# Fig. 1b

## EP 2 747 292 A1

**Description**

**Field of the invention**

The invention relates to a method of optical data transmission using a soft-decision forward error decoding scheme, as well as an optical data transmitter, an optical data receiver, a data encoder for an optical data transmitter, a data decoder for an optical data receiver and an optical data transmission system.

**Background**

In an optical data transmission relying on forward error correction (FEC) encoding, information data may be protected by means of FEC encoding. At a receiving side, FEC decoding may be applied to the received data, for retrieving the transmitted information data with a minimised number of errors.

Successive bits of information data are encoded as a set of information data bits in a so-called information word. Such an information word may also be called an information data vector. For such an information word, a parity bit-word containing additional parity bits is then generated using an FEC encoding algorithm. In the case, that an FEC encoding algorithm is a systematic FEC code, the resulting code word contains the unchanged information word as well as the generated parity bit-word.

The resulting code word is then transmitted, by modulating the phase and/or the amplitude of an optical signal in dependence on the code word bits of the code word.

At a receiving side, the optical signal received is used for deriving for the respective code word bits of a potentially received code word respective likelihood values. Such likelihood values may be probability values or in other words reliability values, which indicate by their scalar values a probability, that the respective code word bit is equal to a value of 0 or 1. Preferably, the probability values are log-likelihood ratio values.

Using the derived probability values, these probability values may be adjusted, and thus possibly improved, using a soft decision FEC decoding algorithm, which corresponds to the FEC encoding algorithm used at the transmitting side.

The adjusted probability values are related to a potentially-received code word. Since the FEC encoding algorithm used at the transmitting side is a systematic FEC encoding algorithm, a subset of the probability values related to a potential code word is equivalent to probability values related to potential received information word. Thus, the adjusted probability values can be used, for deriving a received potential information word. Such a derivation may be carried out, by performing a hard decision detection on the subset of the probability values related to the potential received information word.

**Summary**

Proposed is a method of optical data transmission using a soft-decision error decoding scheme. The method comprises different steps.

A provided information word and a pre-defined bit-word are concatenated, for yielding an extended information word.

A code word is derived, by FEC encoding the extended information word, wherein the FEC encoding is carried out using a first systematic FEC encoding scheme. The resulting code word contains the provided information word, the pre-defined bit-word and the first parity word, since the first FEC encoding scheme is a systematic FEC encoding scheme.

A modified code word is derived, by FEC encoding the information word and the first parity word. For this, a second systematic FEC encoding scheme is used. The resulting modified code word contains the information word, a second parity word and the first parity word. This is due to the fact, that the second FEC encoding scheme is a systematic encoding scheme.

Finally, the modified code word is transmitted using a phase-modulated optical signal.

Further steps are carried out at the receiving side.

From the transmitted optical data signal, likelihood values of a potential modified code word are derived.

Using the likelihood values of the potential modified code word, likelihood values for a potential information word and furthermore likelihood values for a potential parity word are derived. For this derivation, a soft-decision FEC decoding scheme is used, which corresponds to the second FEC encoding scheme.

Pre-defined likelihood values, which correspond to the pre-defined bit-word, are provided.

The likelihood values of the potential information word, the likelihood values of the potential parity word and of the likelihood values of the pre-defined likelihood values are then used, to derive adjusted likelihood values for the potential information word. For this, a soft-decision FEC decoding scheme is used in response to the first FEC encoding scheme.

In order to grasp the advantages of the proposed method, the following aspects have to be taken into consideration.

The proposed method is capable of deriving adjusted likelihood values for a potential information word. Such adjusted likelihood values may then be used for finally deriving directly or indirectly a received information word. When attempting to derive directly a received information word from the adjusted likelihood values, these values may be provided to a hard-decision decoding step. When attempting to derive a received information word indirectly from the adjusted likelihood values, these adjusted likelihood values of the potential information word may be provided to a further iteration step for adjusting the likelihood values of the potential information word furthermore, before finally providing such re-adjusted values of the potential information word to a hard-decision decoding step in order to derive the received information word.

A further advantage is that when trying to transmit data by means of one or more modified code words at a constant data rate, the robustness of the FEC algorithm on the one hand side and the information data rate provided via the size of the information word on the other hand side may be counterbalanced. Assuming a given constant data rate for data transmission by means of the modified code word, the FEC encoding and decoding algorithm may be made more robust, by reducing the size of the information word and at the same time increasing the size of the pre-defined bit word. This causes a reduction of the information data rate but also achieves a more robust FEC encoding and decoding scheme.

In other words, reducing the size of the information word at the same time implies to increase the size of the predefined bit-word as well as the size of the second parity word, which in turn results in a more robust FEC encoding by means of the second systematic FEC encoding algorithm.

Such possible counterbalancing between the information data rate on the one hand side and the robustness of the overall FEC decoding and encoding scheme on the other hand side is of advantage, since this allows to adapt the overall algorithm in dependence on channel properties for specific transmission channels. When attempting to transmit information data over a shorter optical transmission distance, it may be expected that transmission errors resulting from this transmission may not be too severe. In such a case, a larger size of the information word with a smaller size of the pre-defined bit-word as well as the second parity word may be chosen.

In the case of attempting to transmit information data over an optical transmission channel of a longer reach, it may be expected that such a longer transmission distance results in a higher number of transmission errors. In such a case, the information data rate, and in turn the size of the information word, may be reduced, while at the same time increasing the size of the pre-defined bit-word as well as the second parity word for the purpose of making the data transmission more robust.

Preferably, the pre-defined bit-word and the second parity word have the same size.

To summarize the above, the proposed method allows to transmit data at a same, constant overall data rate for the modified code word, while an overall information data rate for the information word may be varied in dependence on an expected number of transmission errors occurring over a given optical data transmission channel.

A further possible advantage of the propose method is that due to the fact that the bit-word which is used for generating the extended information word is a pre-defined bit-word. Thus, since such a pre-defined bit-word may be known at a receiving side, it is also possible, to provide pre-defined likelihood values, which correspond to the pre-defined bit-word, at the receiving side. In other words, when agreeing between a transmitter and a receiver that the transmitter inserts into the extended information word one specific pre-defined bit-word, this data of the pre-defined bit-word does not have to be transmitted over the optical transmission channel but only has to be used for FEC encoding. But still, although the pre-defined bit-word itself is not transmitted, it is possible to take this pre-defined bit-word into consideration for the first systematic FEC encoding scheme as well as the corresponding FEC decoding scheme at the receiving side, since the corresponding pre-defined likelihood values can be chosen at the receiving side. Thus, the pre-defined bit-word can be taken into consideration for FEC encoding at the transmitting side as well as for FEC decoding at the receiving side, without having to transmit the pre-defined bit-word itself over the optical transmission channel.

**Brief description of the Figures**

Figure 1a shows different steps carried out at a transmitting side.

Figure 1b shows different steps carried out at a receiving side according to a preferred embodiment.

Figure 2 shows details of a transmission step.

Figure 3 shows a step of hard-decision detection.

Figure 4a shows steps of generating an information word.

Figure 4b shows steps of deriving data from a received information word.

Figure 5 shows further steps carried out at a receiving side according to a preferred embodiment.

Figure 6 shows steps of soft-decision FEC decoding according to a preferred embodiment.

Figure 7 shows different values occurring when carrying out soft-decision decoding relying on a repetition code according to the preferred embodiment.

Figure 8 shows steps of soft-decision FEC decoding relying on a repetition code, according to a further preferred embodiment.

Figure 9 shows different values occurring when carrying out soft-decision FEC decoding relying on the repetition code, according to the further preferred embodiment.

Figure 10 shows different steps of soft-decision FEC decoding when relying on a parity check code, according to a first embodiment.

Figure 11 shows different steps of soft-decision FEC decoding when relying on a parity check code, according to a second embodiment.

Figure 12a shows different steps of soft-decision FEC decoding when relying on a parity check code as well as an accumulation of parity check bits, according to a first embodiment.

Figure 12b shows accumulation steps for generating accumulated parity check bits.

Figure 13 shows steps of soft-decision FEC-decoding when relying on a parity check code as well as an accumulation of parity check bits, according to a second embodiment.

Figure 14 shows different steps of soft-decision FEC decoding when relying on a parity check code as well as an accumulation of parity check bits according to a third embodiment.

Figure 15 shows different steps of soft-decision FEC decoding when relying on an LDPC code as the second systematic FEC encoding scheme according to a first embodiment.

Figure 16 shows steps of soft-decision FEC decoding when relying on an LDPC code as the second systematic FEC encoding scheme according to a second embodiment.

Figure 17 shows decoding steps in which the size of a pre-defined bit word, the size of a second parity word and the size of an information word are adaptable.

## Description of embodiments

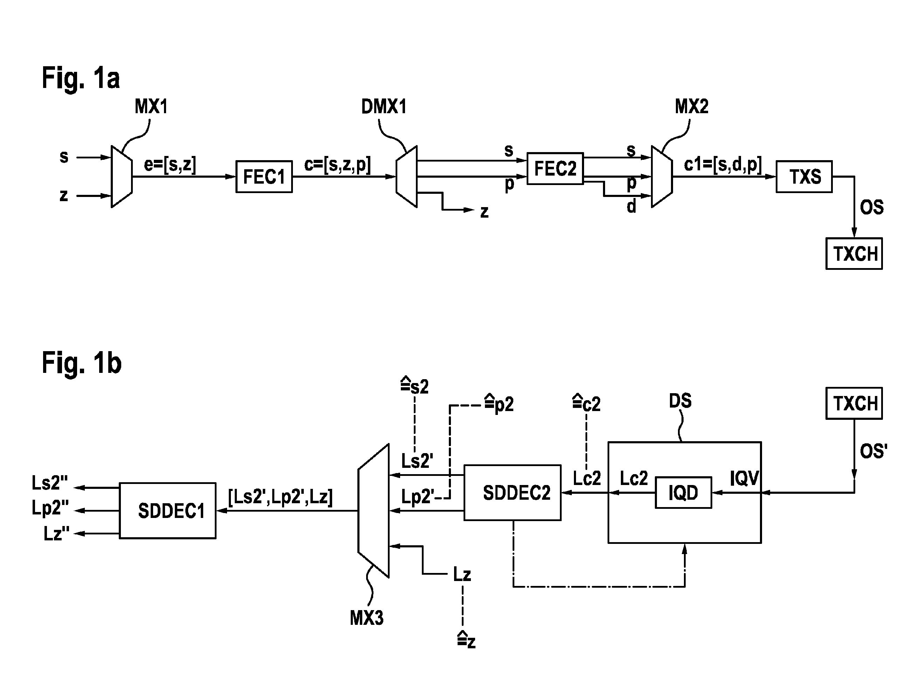

Figure 1a shows different steps carried out at a transmitting side.
The provided information word s is concatenated with a pre-defined bit-word z in a multiplexing step MX1. The information word

$$s = [s_1, \ldots, s_N] \ , \ \text{index } n = 1, \ldots, N$$

is preferably of the size N. The pre-defined bit-word

$$z = [z_1, \ldots, z_M] \ , \ \text{index } m = 1, \ldots, M$$

is a pre-defined bit pattern, or in other words a pre-defined bit vector, which is preferably of the size M.

The concatenation yields an extended information word e. The extended information word

$$e=[\,s\,,z\,]$$

is of the size N+M.

In an FEC encoding step FEC1, the extended information word e is FEC encoded for deriving a code word c. The code word

$$c=[\,e\,,\,p\,]=[\,s\,,z\,,\,p]$$

of the size N+M+P thus contains the information word s, the pre-defined bit-word z and a first parity word p.

In detail, the parity bit-word p is given as

$$p=[p_1,\ ...,\ p_P]\ \ ,\ index\ p=1,\ ...,\ P.$$

The encoding step FEC1 uses a first systematic FEC encoding algorithm. Preferably, this first FEC encoding algorithm is a low density parity check (LDPC) encoding algorithm. Alternatively, this FEC encoding algorithm is a systematic turbo coding algorithm.

In a demultiplexing step DMX1, the pre-defined bit-word z contained within the code word c is disregarded. The information word s as well as the first parity word p are provided to a second step of FEC encoding FEC2.

Using the information word s and the first parity word p, a modified code word c1 is derived. This is preferably carried out, by performing systematic FEC encoding on the information word s and the first parity word p, which yields a second parity word d. The parity word d is given as

$$d=[d_1,\ ...,\ d_D]\ \ ,\ index\ d=1,\ ...,\ D\ .$$

Preferably, the size D of the parity bit-word d is of the same size as the pre-defined bit-word z. This leads to D=M.

The modified code word c1 is then given as

$$c1=[\,c1_1,\ ...,\ c1_C]\ =[\,s\,,d\,,\,p\,]\,,$$

wherein the size of the modified code word c1 is C= N+M+P.

Preferably, the second systematic FEC encoding algorithm is a Parity-Check-Coding scheme. Alternatively, the second systematic FEC encoding algorithm is a Repetition-Coding scheme.

In the multiplexing step MX2, the information word s, the parity word d and the parity word p are concatenated to yield the modified code word c1. In other words, by disregarding the pre-defined bit-word z, generating the parity word d and then concatenating the information word s, the parity word d and the parity word p in the proposed manner, a replacement of the pre-defined bit-word z by the parity word d within the code word c is carried out, in order to yield the modified code word c1.

Due to the fact that the bit-word z is a pre-defined bit-word, this bit-word z does not have to be transmitted itself later on over an optical transmission channel, since a receiving side may be notified in advance, which pre-defined bit-word z was used for FEC encoding in the step FEC1.Thus, the necessary data rate that would be needed to transmit the pre-defined bit-word z over the transmission channel can instead be used for transmitting the parity word d, which was generated for additional FEC error protection of the information word s and the parity word p.

Within a transmission step TXS, a phase-modulated optical signal OS is generated for transmitting the modified code word c1. The phase-modulated optical signal OS is preferably generated, using a phase-modulation scheme. Examples of phase-modulation schemes are Binary Phase Shift Keying (BPSK) or Quadrature Phase Shift Keying. More preferably, the phase-modulated optical signal OS is generated, by modulating the phase and an amplitude of an optical signal, using a corresponding phase-and-amplitude modulation scheme. An example of a phase-and-amplitude modulation scheme is 16 Quadrature Amplitude Modulation (16 QAM).

Preferably, before providing the modified code word c1 to the transmission step TXS, the code word bits of the modified code word c1 may be differentially encoded by means of a differential encoder. Such a differential encoding is not shown explicitly within Figure 1a.

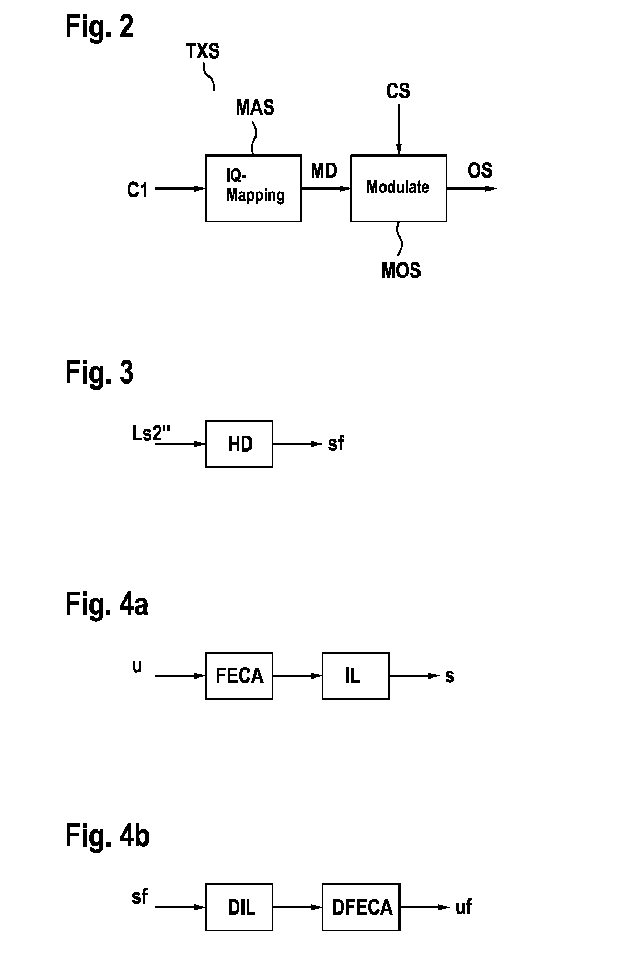

Figure 2 shows the transmission step TXS in further detail. The modified code word c1 is provided to a mapping step MAS, which performs IQ mapping of the data bits of the modified code word c1 to mapping data MD. Preferably, such mapping data are I (in-phase) and Q (quadrature) phase-values. In dependence on the modulation data MD, the optical carrier signal CS is modulated in a modulation step MOS, for generating the optical transmission signal OS. Such a modulation modulates at least a phase of the optical carrier signal CS. Preferably, the modulation includes also amplitude modulation of the optical carrier signal CS. In the case that only the phase of the optical carrier signal CS is modulated, the mapping as well as the modulation is preferably carried out according to a quadrature phase-shift keying (QPSK) modulation method. In the case, that the mapping as well as the modulation is carried out, such that the phase and the amplitude of the optical carrier signal CS are modulated, this is performed in dependence on a 16 QAM (quadrature amplitude modulation) modulation scheme.

Coming back to Figure 1a, the modulated optical transmission signal OS is transmitted over an optical transmission channel TXCH.

Figure 1b shows different steps carried out at a receiving side.

A transmitted optical signal OS' is received from the optical transmission channel TXCH.

From the optical signal OS', likelihood values Lc2 of a potential modified code word are derived. This derivation is preferably carried out by deriving from the amplitude and/or the phase of the optical signal OS likelihood values for respective modified code word bits of the potential modified code word. This is carried out in a derivation step DS. For this, the derivation step DS performs preferably also the step of IQ de-mapping IQD, which may be carried out for example according to the algorithm disclosed in the document "'Iterative demapping and decoding for multilevel modulation', ten Brink, S.; Speidel, J.; Ran-Hong Yan, Global Telecommunications Conference (GLOBECOM), 1998, Page(s): 579 - 584 vol.1". In this document, the equation number 4 teaches how use likelihood values as edges of a graph for performing the de-mapping. Alternatively, the step of IQ de-mapping IQD is carried out according to the algorithm described in the document "Turbo Equalization, Signal Processing Magazine, IEEE, Jan. 2004, Koetter, R., Singer, A.C., Tüchler, M. , Volume 21 , Issue 1, Pages 67 - 80".

Within Figure 1b, the IQ de-mapping step IQD derives from complex IQ-data, which is obtained from the optical data signal OS, likelihood values Lc2 of a further modified code word c2.

Figure 1a does not in detail show a differential encoding of the modified code word c1. Preferably, such a differential encoding of the code word c1 is carried out at the transmitting side. In the case that this code word c1 is differentially encoded, then the derivation step DS shown in Figure 1b will use a de-mapping scheme IQD which is modified, such that it accounts for such differential encoding.

Further examples of deriving likelihood values from phase and/or an amplitude of a received optical signal are given in the published patent application EP 11160751.1.

The vector

$$Lc2 = [Lc2_{1,\,...,}\, Lc2_C] = [\, Ls2_{1,\,...,}\, Ls2_N \,,\, Ld2_{1,\,...,}\, Ld2_D \,,\, Lp2_{1,\,...,}\, Lp2_P \,] \,,\, \text{size } C$$

contains respective likelihood values, which are preferably log-likelihood values. These values indicate respective probabilities that the respective potential modified code word bits contained in the vector of the potential modified code word

$$c2 = [\, c2_1, \,...,\, c2_C] = [\, s2 \,,\, d2 \,,\, p2 \,] \,,\, \text{size } C = N+M+P$$

are of the value 0 or 1.

The likelihood values Lc2 of the potential modified code word c2 are then provided to a step of soft-decision FEC decoding SDDEC2. The step SDDEC2 uses a soft-decision FEC decoding scheme, which corresponds to the systematic FEC encoding scheme used within the step FEC2 on the transmitting side, shown in Figure 1a.

Thus, the step SDDEC2 derives from the likelihood values Lc2 of the potential modified code word c2 likelihood values Ls2' of a potential information word s2 as well as likelihood values Lp2' for a potential first parity word p2. The likelihood values

$$Ls2' = [Ls2'_{1,\,...,}\, Ls2'_N] \,,\, \text{index } n = 1, \,...,\, N$$

indicate respective probability values for the potential information word

$$s2 = [\, s2_1, \dots, s2_N ]\,.$$

The likelihood values

$$Lp2' = [\, Lp2'_{1, \dots,} Lp2'_P \,]\,, \; \text{index } p = 1, \dots, P$$

indicate respective probability values for a potential first parity word

$$p2 = [\, p2_1, \dots, p2_P].$$

Preferably, the step SDDEC2 derives from the likelihood values $Lc2$ of the potential modified code word $c2$ also likelihood values $Ld2'$ of a potential second parity word d.

The likelihood values

$$Ld2' = [Ld2'_{1, \dots,} Ld2'_M ]\,, \; \text{index } n = 1, \dots, M$$

indicate respective probability values for the potential first parity word

$$d2 = [\, d2_1, \dots, d2_M]\,.$$

Such likelihood values $Ld2'$ may then be used in a further iteration step, as it will be described in detail later on.

Detailed examples for generating likelihood values $Ls2'$ of a potential information word $s2$ as well as likelihood values $Lp2'$ for a potential first parity word $p2$ in the step SDDEC2 will be given later on for the example of a repetition code and the example of a parity check code.

It is furthermore shown in Figure 1b, that pre-defined likelihood values $Lz$ are provided. These likelihood values $Lz$ are pre-defined, in that they correspond to the pre-defined bit-word z that was previously provided and used on the transmitting side, as illustrated in Figure 1a. The log-likelihood values $Lz$ are preferably a vector

$$Lz = [\, Lz_{1, \dots,} Lz_M \,]\,, \; \text{index } m = 1, \dots, M\,,$$

which corresponds to the pre-defined bit-word z as the vector

$$z = [z_1, \dots, z_M]\,.$$

For example, in the case that the pre-defined bit-word z contains only zeros, the corresponding likelihood values $Lz$ take on the value of $+\infty$.

In another example, in which the likelihood values z are chosen to be a sequence consisting of bits equal to 1, the likelihood values $Lz$ may be chosen on the receiving side to a sequence of log-likelihood ratio values consisting only of the value $-\infty$.

Thus, by using a pre-defined bit pattern z at the transmitting side, this bit pattern may be used for FEC encoding within the step FEC1, as shown in Figure 1a, although later on this bit pattern z is removed from the code word c and then replaced by the parity word d within the modified code word c1, but still the knowledge of this pre-defined bit-word z can be used on the receiving side for FEC decoding, when providing the likelihood values $Lz$, which correspond to the pre-defined bit pattern z.

The likelihood values $Ls2'$ of the potential information word, the likelihood values of the potential first parity word $Lp2'$ and the pre-defined likelihood values $Lz$ are then provided to a soft-decision FEC decoding algorithm, which is shown here as a step SDDEC1. This soft-decision FEC decoding algorithm is an algorithm, which corresponds to the first FEC decoding algorithm used within the step FEC1 shown in Figure 1a. In the case of relying on an LDPC code, the soft-decision FEC decoding algorithm may be carried out as described in detail in the document "Frank R. Kschischang, Brendan J. Frey, Hans-Andrea Loeliger,'Factor graphs and the sum-product algorithm', IEEE TRANSACTIONS ON INFORMATION THEORY, VOL. 47, NO. 2, FEBRUARY 2001 ". In the case that the first FEC encoding algorithm relies on a Turbo Code, the soft-decision FEC decoding algorithm may be carried out as described in detail in the document "J. Hagenauer, E. Offer, L. Papke, 'Iterative Decoding of Binary Block and Convolutional Codes', IEEE TRANSACTIONS ON INFORMATION THEORY, Vol.42, No.2, March 1996".

The soft-decision FEC decoding algorithm of the step SDDEC1 derives at least adjusted likelihood values Ls2" for the potential information word s2. Preferably the soft-decision decoding of step SDDEC1 derives also adjusted likelihood values Lp2' for the potential first parity word p2. Even more preferably, the soft-decision decoding of step SDDEC1 derives also adjusted likelihood values Lz" for the pre-defined bit-word z.

The adjusted likelihood values Ls2" may be used for deriving either directly or indirectly a received information word. In the case that the adjusted likelihood values Ls2" are used directly for deriving a received information word, then these adjusted likelihood values Ls2" are a-posteriori likelihood values.

Figure 3 shows a first alternative for deriving a received information word sf using a-posteriori likelihood values Ls2". According to this alternative, the adjusted likelihood values Ls2" are provided to a hard-decision step HD, which carries out a hard decision detection on the likelihood values Ls2" for obtaining data bits of the received information word sf.

Coming back to Figure 1b, it can be said that the steps of deriving the likelihood values Lc2, the likelihood values Ls2' and the likelihood values Lp2', providing the likelihood values Lz, and deriving the adjusted likelihood values Ls2" are carried out in a first iteration step. This first iteration step may contain also a derivation of adjusted likelihood values Lp2" for the potential first parity word p2.

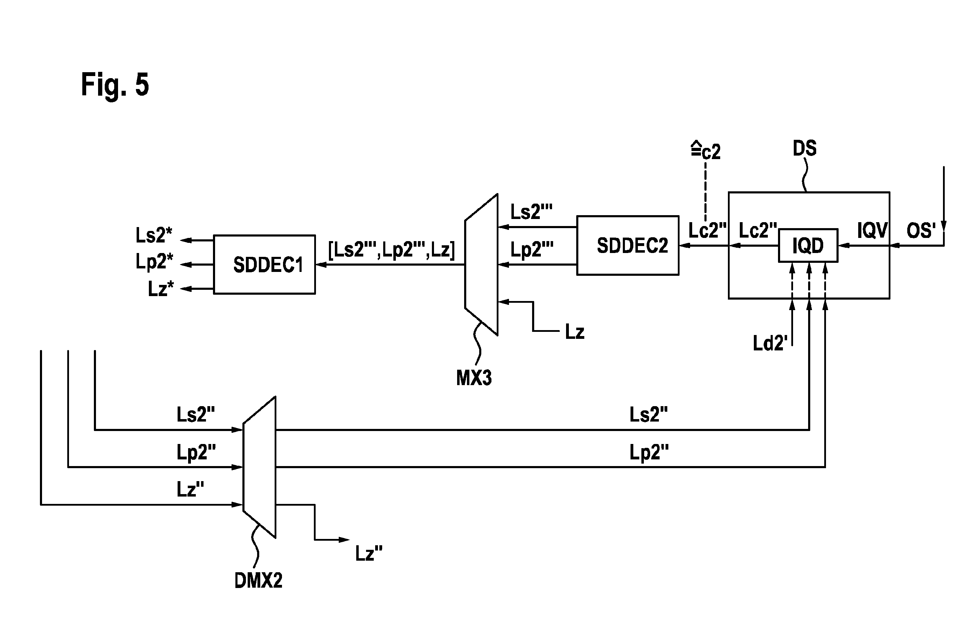

According to a further alternative for deriving a received information word sf, the adjusted likelihood values Ls2" of the potential information word s2 are used indirectly, for deriving the received information word sf. In this case, the adjusted likelihood values Ls2" are extrinsic likelihood values. Such an indirect derivation is shown in Figure 5, wherein this Figure 5 shows a further, second iteration step with sub-steps in detail.

For deriving a received information word, the adjusted likelihood values Ls2" and Lp2", as derived in the first iteration step, are used. As previously mentioned, the adjusted likelihood values Ls2" are extrinsic likelihood values. In the case, that adjusted likelihood values Lz" had been derived within the first iteration step, then these adjusted likelihood values Lz" are disregarded. Such disregarding may be carried out within a demultiplexing step DMX2.

The adjusted likelihood values Ls2" and the adjusted likelihood values Lp2" are provided to the de-mapping step DS, which has been described in detail previously with regard to Figure 1b. Furthermore, the previously mentioned likelihood values Ld2', which were preferably derived within the first iteration step as shown in Figure 1b, are also provided to the de-mapping step DS. Within the de-mapping step DS, IQ de-mapping IQD is carried out using the provided likelihood values Ls2", Lp2" and Ld2', for deriving from the optical signal OS updated likelihood values Lc2" for the potential modified code word c2. Such iterative decoding or derivation of likelihood values Lc2" using the previously determined likelihood values Ls2", Lp2" and Ld2' has been described in detail in the document "'Iterative demapping and decoding for multilevel modulation', ten Brink, S.; Speidel, J.; Ran-Hong Yan, Global Telecommunications Conference (GLOBECOM), 1998, Page(s): 579 - 584 vol.1".

From the updated likelihood values Lc2" of the potential modified code word c2, further likelihood values are derived. In detail, this derivation is carried out within a soft-decision FEC decoding step SDDEC2 as previously described with regard to Figure 1b. This decoding step SDDEC2 uses the previously mentioned soft-decision decoding algorithm that corresponds to the second FEC encoding scheme. The results of the decoding step SDDEC2 are updated likelihood values Ls2''' of the potential information word s2 and updated likelihood values Lp2''' of the potential first parity word p2. Within a multiplexing step MX3, as previously described with respect to Figure 1b, the pre-defined likelihood values Lz are provided.

From the updated likelihood values Ls2''', Lp2''' and the provided likelihood values Lz, further adjusted likelihood values Ls2* are derived for the potential information word s2, using the soft-decision FEC decoding algorithm SDDEC1, which corresponds to the first FEC encoding scheme. This derivation is carried out within the decoding step SDDEC1, which was previously mentioned with regard to Figure 1b.

Using the further adjusted likelihood values Ls2*, it is now possible to derive via a hard-decision step HD the received information word sf.

Preferably, the decoding step SDDEC1 also performs a derivation of further adjusted likelihood values Lp2* for the potential first parity word p2. Even more preferably, the decoding step SDDEC1 determines also further adjusted likelihood values Lz* for the pre-defined bit-word z.

As it is clear for a person skilled in the art, the second iteration step, as shown in detail in Figure 5, does not necessarily have to lead to a termination of iteration steps, by deriving the received information word sf directly from the further adjusted likelihood values Ls2*. More preferably, the further adjusted likelihood values Ls2* of the potential information word s2 and the further adjusted likelihood values Lp2* of the potential first parity word p2 may be used in an even further iteration step, not explicitly shown in Figure 5, for deriving via the encoding step FEC2, the derivation step DS, the encoding step SDDEC2, the multiplexing step MX3 and the further decoding step SDDEC1 likelihood values for the information word s2, which are even furthermore updated.

In the case, that the further adjusted likelihood values Ls2* of the potential information word s2 are directly used for deriving a received information word sf using a hard-decision detection, as previously mention with regard to Figure 3, then the adjusted likelihood values Ls2* are a-posteriori likelihood values. In the case, that the further adjusted likelihood values Ls2* of the potential information word s2 are used in an even further iteration step, then the adjusted likelihood values Ls2* are extrinsic likelihood values.

Coming back to Figure 1a, it is to be mentioned that preferably the size of the information word s, the size of the pre-defined word z and the size of the second parity word d are selectable in dependence on a pre-defined information data rate, provided via the information word s, and a pre-defined overall data rate, provided by the modified code word c1. As a non-limiting example, it may be assumed that an overall data rate of the modified code word c1 is constant, while the information data rate for the information word s is selectable. Assuming that the information data rate is smaller than the overall data rate, a difference of these data rates may then be employed, by choosing the size of the pre-defined bit-word z as well as the size of the second parity word d to a specific value. This difference of the data rates allows one to insert a specific number of pre-defined bits within the bit-word z as well as a same number of parity bits within the second parity word d. Thus, when reducing the information data rate of the information word s, this allows one to perform forward error encoding via the pre-defined bit-word z as well as the second parity word d to a certain extent. In case of further reducing the information data rate for the information word s, this allows one to further apply a higher level of FEC encoding via the pre-defined bit-word z and the second parity word d. Thus, in the case of expecting a certain amount of signal affection by the optical channel TXCH onto the optical signal OS, the proposed method allows one to choose the amount of FEC encoding that is applied to the information word s. Thus, the proposed method provides a flexible algorithm for choosing between a desired information data rate for the information word s on the one hand side and a necessary amount of FEC encoding on the other hand side.

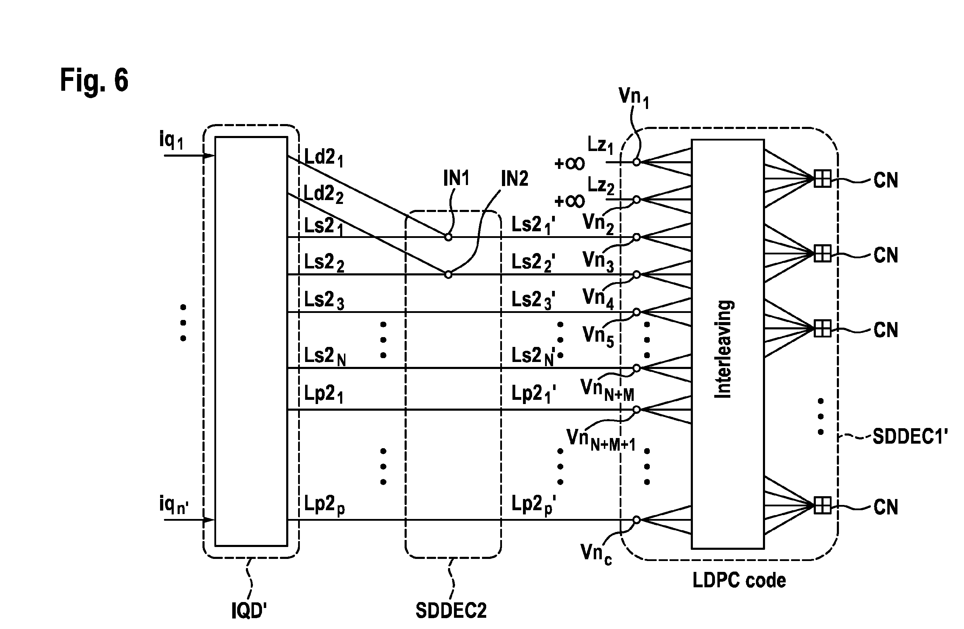

Figure 6 shows sub-steps of decoding according to a preferred embodiment. In this embodiment, a decoding is carried out for the case, that a repetition code has been used as the second FEC encoding algorithm at the transmitting side.

Complex I/Q values $iq_1$..., $iq_{n'}$, which had been previously derived from the received optical signal, are provided to a step IQD' of IQ de-mapping. The step IQD' derives from the n complex IQ values the likelihood values $Lc2_1$,..., $Lc2_C$, which correspond the shown respective likelihood values $Ld2_1$,...,$Ld2_D$, $Ls2_1$,..., $Ls2_N$, $Lp2_1$,..., $Lp2_P$.

It is assumed, as a non-limiting example, that a repetition code had been carried out at the transmitting side in the way that the first bit of the information word s had been repeated as a first parity bit of the parity bit-word d. Furthermore, as the non-limiting example, the second bit of the information word s had been repeated as a second bit of the parity bit-word d. Thus, within a step of soft-decision decoding SDDEC2', the likelihood value $Ls2_1$ is added to the likelihood value $Ld2_1$ at an intermediate node IN1, which can be considered as a variable node. Furthermore, at a further variable node as an intermediate node IN2, the likelihood value $Ls2_2$ is added to the likelihood value $Ld2_{d=2}$.

Thus, the step SDDEC2 yields the likelihood values $Ls2_1'$ and $Ls2_2'$.

The likelihood values provided by the step SDEEC2' are then concatenated with the pre-defined likelihood values $Lz_1$ ,..., $Lz_{2=M}$ . In this example, the pre-defined bit-word z consisted only of zeros, such that the pre-defined likelihood values $Lz_1$ and $Lz_2$ are chosen to the value $+\infty$.

Within a decoding step SDDEC1', the soft-decision decoding algorithm corresponding to the first FEC encoding algorithm is carried out, using variable nodes $Vn_1$ ,..., $Vn_C$ as well as check nodes CN.

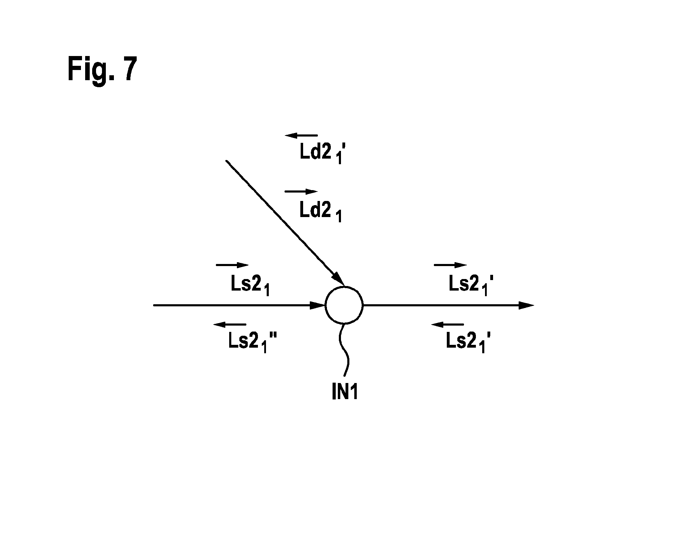

Figure 7 shows the variable intermediate node IN1 for the example given in Figure 6 in detail together with likelihood values present at this intermediate node IN1.

The incoming likelihood value $\vec{L}d2_1$ is added with the incoming likelihood values $\vec{L}s2_1$, in order to yield the outgoing likelihood value $\vec{L}s2_1'$, as previously described in detail, given as

$$\vec{L}s2_1' = \vec{L}s2_1 + \vec{L}d2_1.$$

The outgoing likelihood value $\vec{L}s2_1''$ is determined as

$$\vec{L}s2_1'' = \vec{L}d2_1 + \vec{L}s2_1'.$$

The outgoing likelihood value $\vec{L}d2_1'$ is determined as

$$\overline{L}\,d2_1{}' = \overline{L}\,s2_1{}' + \vec{L}\,s2_1.$$

Such outgoing likelihood values shown in Figure 7 correspond to the likelihood values determined within Figure 5 by the step FEC2.

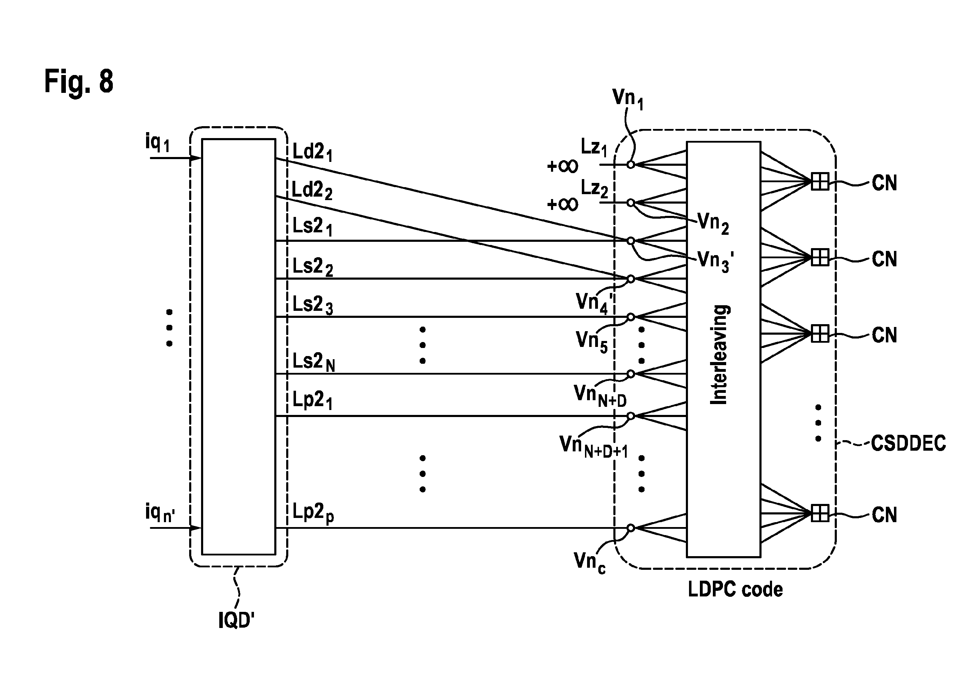

Figure 8 shows the previously mentioned de-mapping step IQD', as well as a combined soft-decision decoding step CSDEC, which combines the operations carried out by the soft-decision decoding steps SDDEC2' and SDDEC1' previously described with regard to Figure 6. According to Figure 6, the variable nodes have the indices $Vn_1$ ,..., $Vn_N$. The variable nodes $Vn_1$ and $Vn_2$ shown in Figure 8 are the same as previously shown in Figure 6. In contrast to this, the variable nodes $Vn_3'$ ,..., $Vn_4'$ of Figure 8 are modified variable nodes.

Within the step CSDEC, the steps of deriving the adjusted likelihood values Ls2", using provided pre-defined likelihood values Lz, are carried out as a combined FEC decoding scheme.

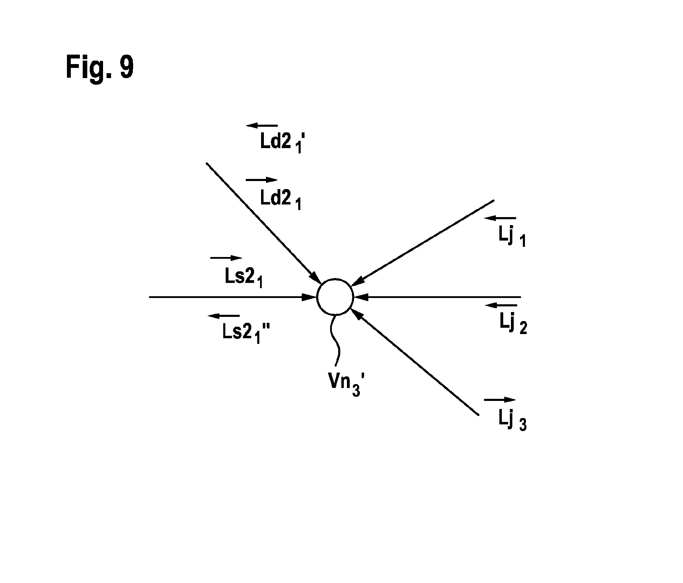

In order to illustrate the computation of incoming and outgoing likelihood values at the modified variable nodes $Vn_3'$, $Vn_4'$, Figure 9 shows such likelihood values for the modified variable node $Vn_3'$ in detail. A sum of all likelihood values coming into the node $Vn_3'$ is defined as

$$S = \vec{L}\,d2_1 + \vec{L}\,s2_3 + \sum_{i=1}^{v}\overline{L}j_i.$$

The outgoing likelihood value $\vec{L}\,d2_1$ is then derived as

$$\overline{L}\,d2_1{}'' = S - \vec{L}\,d2_1.$$

Furthermore, the outgoing likelihood value $\vec{L}\,s2_1$" is then derived as

$$\overline{L}\,s2_1{}'' = S - \vec{L}\,s2_1.$$

The variable nodes and check nodes are connected by an interleaving scheme defined by the soft-decision decoding scheme corresponding to the first FEC encoding algorithm.

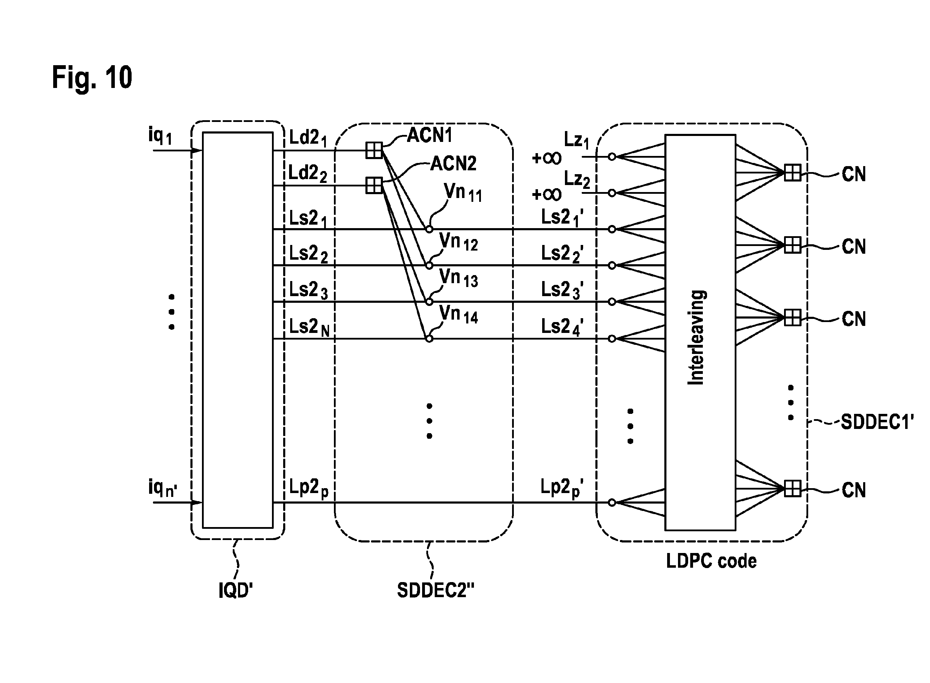

Figure 10 shows the IQ de-mapping step IQD' together with the decoding step SDDEC1' in combination with a further soft-decision decoding step SDDEC2" in the case, that the parity check code had been used on the transmitting side as the second FEC encoding algorithm.

In this example, the parity check code performed a modulo-2 addition of the first two bits of the information word in order to yield first bit of the second parity word as $d_1 = s_1 \oplus s_2$.

Furthermore, the parity code in this example performed a modulo-2 addition of the third and the fourth bit of the information word in order to yield the second bit of the second parity bit-word as $d_2 = s_3 \oplus s_4$.

Due to the parity check performed as code encoding at the transmitting side, the likelihood value $Ld2_1$ and likelihood values $Ls2_1$ and $Ls2_2$ are connected via an additional check node ACN1 as well as variable nodes $Vn_{11}$ and $Vn_{12}$. The likelihood value $Ld2_2$ and the likelihood values $Ls2_3$ and $Ls2_4$ are connected via an additional check node ACN2 and the variable nodes $Vn_{13}$ and $Vn_{14}$, respectively.

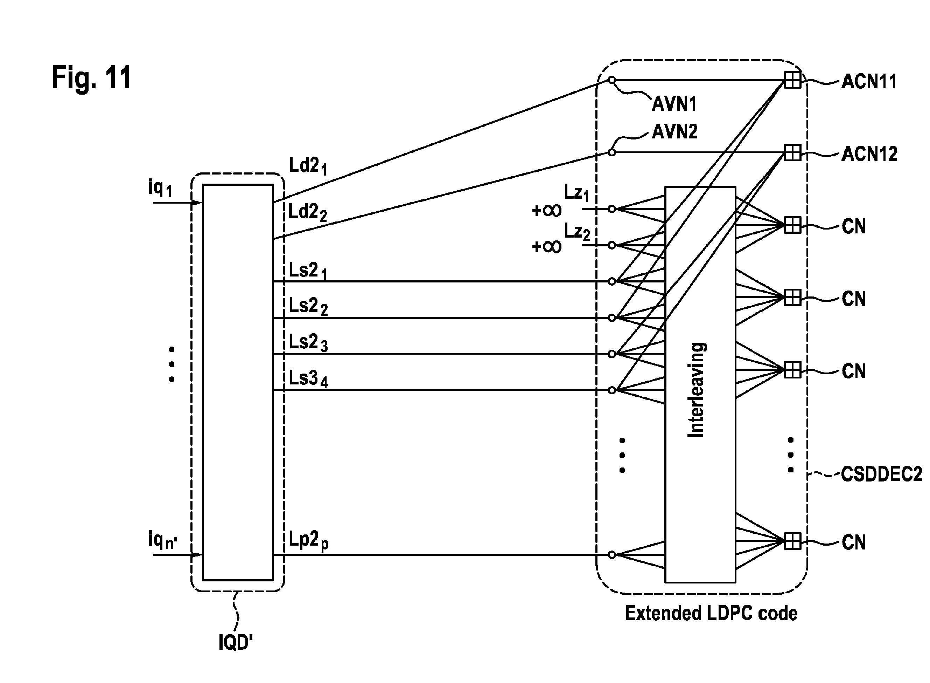

Figure 11 shows a combined decoding step CDDEC2, in which a combined FEC decoding scheme is carried out in the case of combining a parity check code as the second FEC encoding algorithm and an LDPC code as the first FEC encoding algorithm on the transmitting side.

This combined soft-decision decoding step CDDEC2 is realised by placing the additional check-nodes ACN11 and ACN 12 in line with the check-nodes CN and by providing additional variable nodes AVN1 and AVN2.

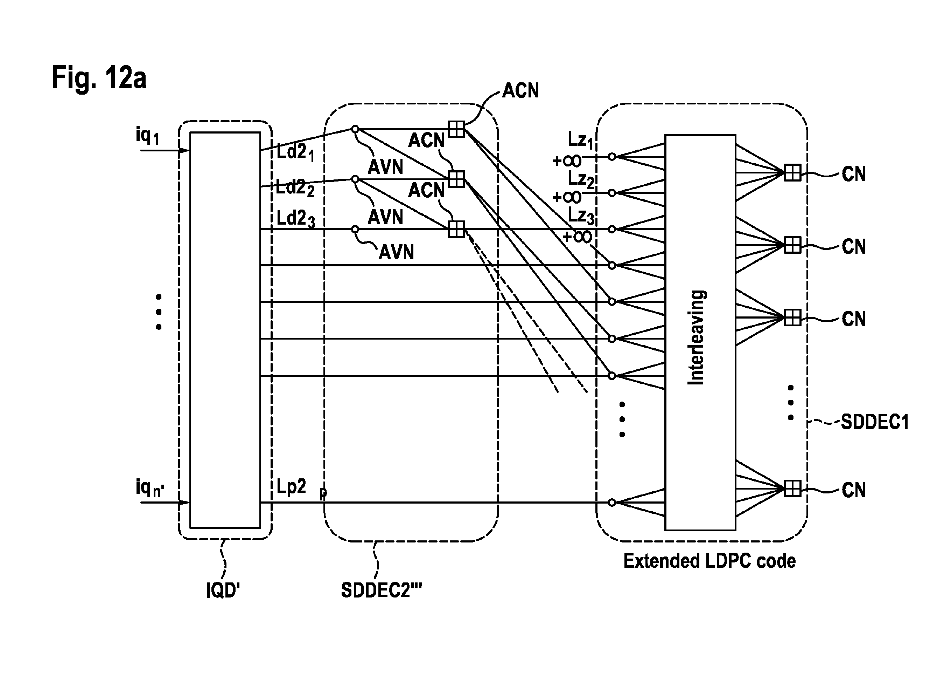

Figure 12a shows the de-mapping step IQD' together with the decoding step SDDEC1 in combination with a soft-decision decoding step SDDEC2''' for the case, that the parity check code generated parity bits were encoded by an accumulation step in the transmitting side.

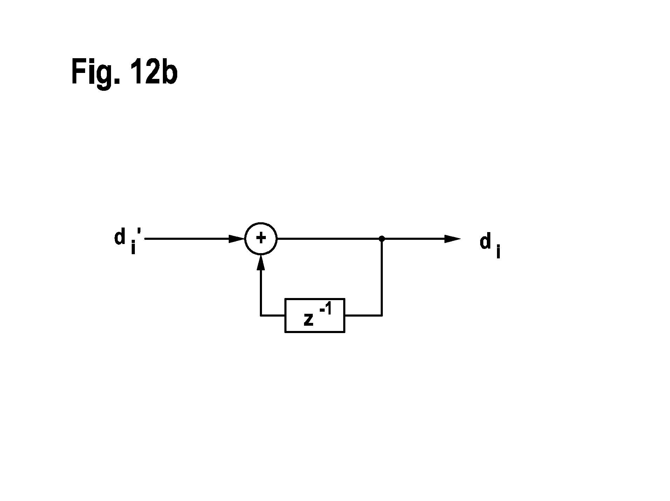

An accumulation step is shown in Figure 12b. The accumulation is carried out by combining bits $d_i'$ generated

by a parity check code and then yielding the final accumulated parity check bits $d_i$.

In an example, in which the parity check code generated bits are three bits determined as:

$$d_1' = s_1 \oplus s_2,$$

$$d_2' = s_3 \oplus s_4,$$

$$d_3' = s_5 \oplus s_6$$

and the accumulation is carried out as

$$d_1 = d_1',$$

$$d_2 = d_1 \oplus d_2',$$

$$d_3 = d_2 \oplus d_3'.$$

The Figure 12a shows the corresponding soft-decision decoding using additional variable nodes AVN as well as additional check nodes ACN.

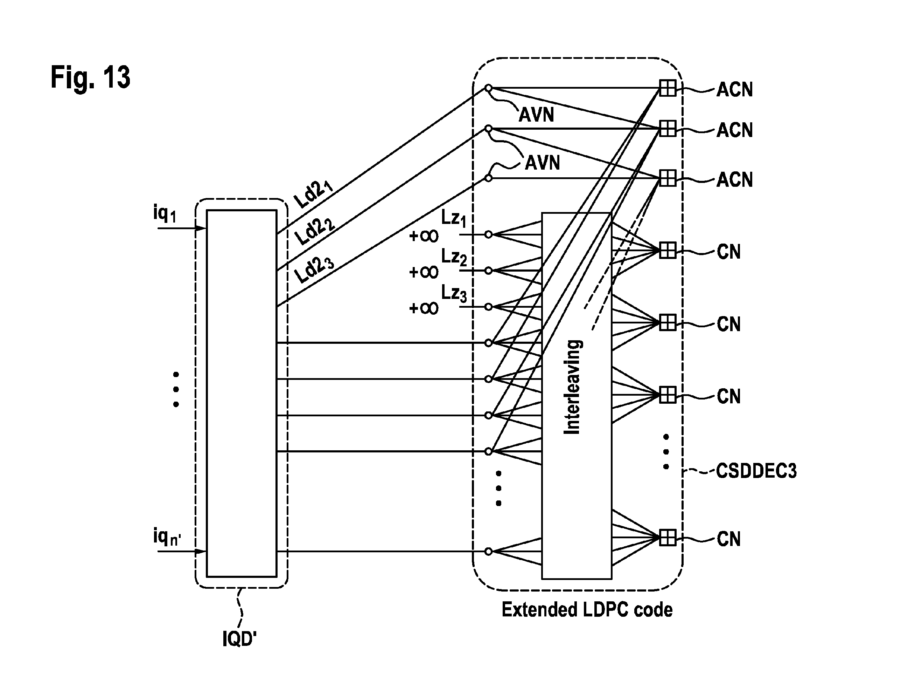

Figure 13 shows the combined soft-decision decoding steps CDDEC3, in which the additional check nodes are placed in line with the other check nodes CN. The additional variable nodes AVN are also contained in the step CDDEC3.

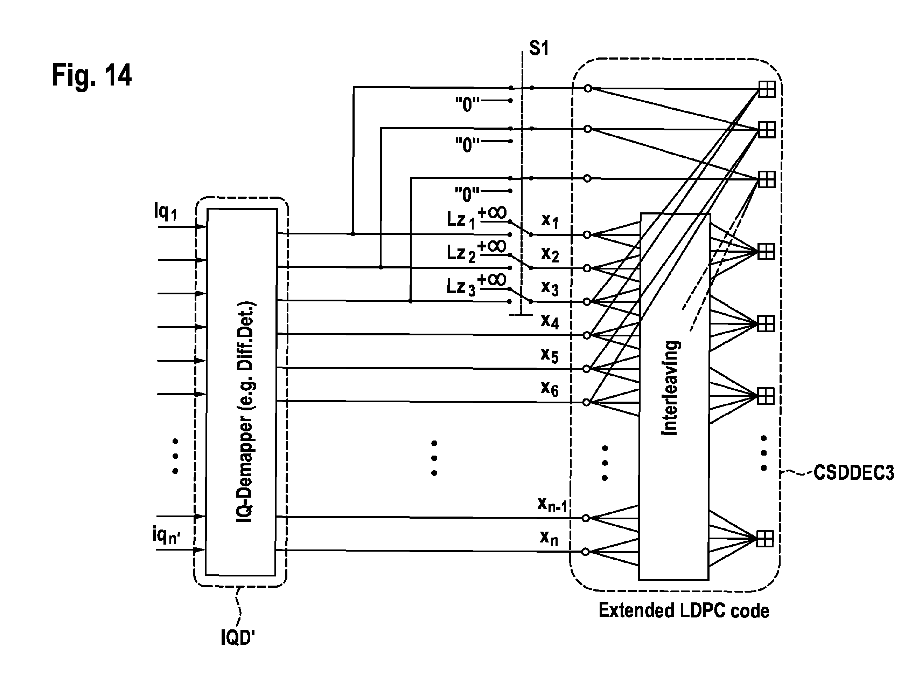

Figure 14 shows the de-mapping step IQD' in combination with the combined soft-decision decoding steps CDDEC3, wherein input values for the step CDDEC3 may be chosen from likelihood values provided by the de-mapping step IQD' or pre-defined likelihood values $Lz_1, ..., Lz_3$ by means of switching. This is shown for the example of using an LDPC code for FEC encoding at the transmitting side.

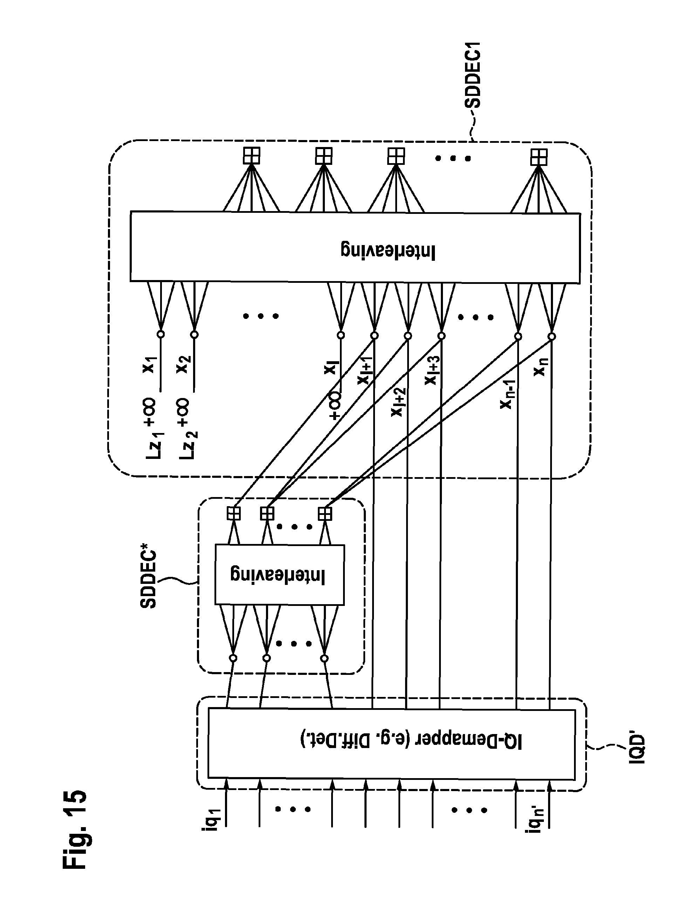

Figure 15 shows the de-mapping step IQD' together with the soft-decision decoding step SDDEC1 in combination with a soft-decision decoding step SDDEC2*, in the case that an LDPC FEC algorithm has been used on the transmitting side as the second FEC encoding algorithm.

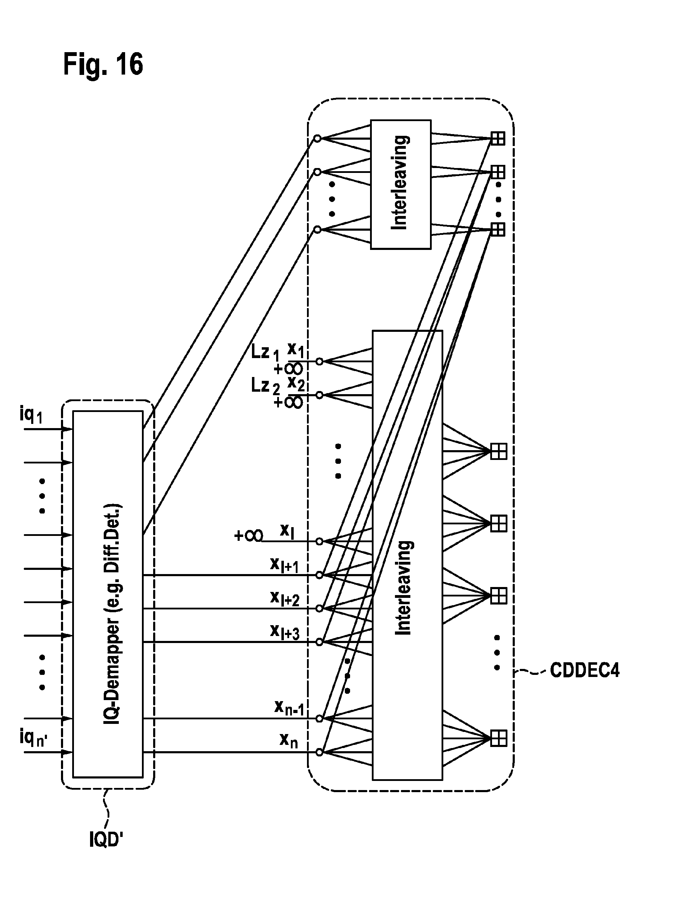

Figure 16 shows a combined decoding step for soft-decision decoding CDDEC4, in which the soft-decision decoding for the first and the second FEC encoding algorithms are carried out in a combined manner, in the example when using an LDPC code for the first and the second FEC encoding algorithms.

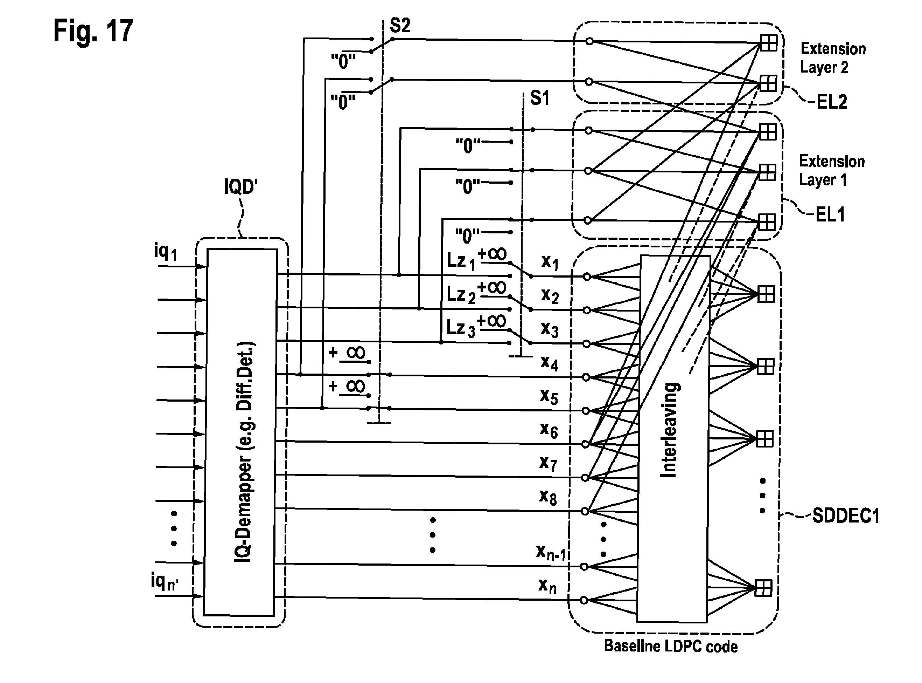

Figure 17 shows the de-mapping step IQD' together with the decoding step SDDEC1.

Furthermore, Figure 17 shows extension layers EL1, EL2, which contain additional check nodes, which are connected to the variable nodes of the decoding step SDDEC1.

A provisioning of values to the extension layers EL1, EL2 as well as the decoding step SDDEC1 is controlled by one or more switches S1, S2.

In the shown configuration of the switches S1, S2, a number of pre-defined likelihood values $Lz_1, ..., Lz_3$ is provided to variable nodes of the decoding step SDDEC1. Thus, the shown structure is able to perform decoding in the case that a pre-defined word z of a corresponding size, in this example the size M=3, has been used at a transmitting side.

Furthermore, a number of likelihood values derived by the demapping step IQD' is provided via the upper elements of the switch S1 to the extension layer, which in turn thus provides values to variable nodes of the decoding step SDDEC1. These provided likelihood values are likelihood values related to a second parity word d generated at a transmitting side. Thus, the shown structure is able to perform decoding in the case that a second parity word d of a corresponding size, in this example the size M=3, has been generated at a transmitting side.

The switching elements of the switch S2 are configured, such that no likelihood values are provided to the second extension layer EL2. Thus, also no values are provided by the extension layer EL2 to variable nodes of the decoding step SDDEC1.

To summarize the above, in this example of configuration, the pre-defined bit word z has a size of M=3 and the second parity word d has a size of M=3. The size of the information word s shall be assumed to be in this case of the value N.

In the case, that all switching elements of the switch S1 are switched to their lower input and that the switching elements of the switch S2 remain configured as shown, then this corresponds to a size of the pre-defined bit word z as M=0 and also the size of the second parity word d as M=0. But, this in turn also results in a considered size N' of the information word s as N'=N+3. Thus, by configuring the switching elements of the switches S1 and S2, this allows to change between two different sets of pre-configured sizes for the pre-defined bit word z, the second parity word d and the information word s.

In the case, that all switching elements of the switch S2 are switched to their upper input and that the switching elements of the switch S1 remain configured as shown, then this corresponds to a size of the pre-defined bit word z as M=5 and also the size of the second parity word d as M=5. But, this in turn also results in a considered size N' of the information word s as N'=N+5. Thus, by the switching elements of the switch S2 allow to change between two different sets of pre-configured sizes for the pre-defined bit word z, the second parity word d and the information word s.

The implemented scheme is shown here for an accumulation of parity bits used for encoding.

The proposed method comprises steps, which may be carried out at a transmitting side and steps that may be carried out at a receiving side.

Preferably, one or more of the steps that may be carried out at a transmitting side are carried out by an optical data transmitter or a data encoder for an optical data transmitter. Encoding steps are preferably carried out by the data encoder, which uses an information word and provides a modified code word. The data encoder is preferably a hardware element such as a processor or a processing unit. The optical data transmitter contains preferably such a data encoder as well as an optical modulation unit, which is operable to modulate an optical transmission signal in dependence to the modified code word and in accordance with a modulation method. The modulation method is preferably a phase- and/or amplitude modulation method. Furthermore, the optical data transmitter contains preferably an optical interface, via which the transmitter transmits the modulated optical transmission signals into an optical transmission link.

Preferably, one or more of the steps that may be carried out at a receiving side are carried out by an optical data receiver or a data decoder for an optical data receiver. Even furthermore, an optical data transmission system may comprise the optical data transmitter and the optical data receiver. Decoding steps are preferably carried out by the data decoder, which derives from phase-values and/or amplitude-values adjusted likelihood-values for a potential information word. From such likelihood values, the data decoder may then derive a received information word. The optical data receiver contains preferably such a data encoder as well as an optical reception unit, which is operable to receive a received optical signal and to derive from the optical signal likelihood-values for a potential code word or phase-values and/or amplitude-values, which are then provided by the reception unit to the data decoder.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the Figures and/or described herein, including any functional blocks named as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context. A person of skill in the art would readily recognize that steps of various above-described methods can be performed by programmed computers and/or processors.

**Claims**

1. Method of optical data transmission using a soft-decision forward error decoding scheme, comprising, at a transmitting side,

    - concatenating a provided information word (s) and a pre-defined bit-word (z), yielding an extended information word (e),
    - deriving a code word (c), by FEC encoding said extended information word (e) using a first systematic FEC encoding scheme, wherein said code word (c) comprises said provided information word (s), said pre-defined bit-word (z) and a first parity word (p),
    - deriving a modified code word (c1), by FEC encoding said information word (s) and said first parity word (p), using a second systematic FEC encoding scheme, wherein said modified code word (c1) comprises said information word (s), a second parity word (d) and said first parity word (p),
    - transmitting said modified code word (c1), using a phase-modulated optical signal (OS),
    furthermore comprising, at a receiving side,
    - deriving from the transmitted optical signal (OS') likelihood-values (Lc2) of a potential modified code word (c2),
    - deriving from said likelihood-values (Lc2) of said potential modified code word (c2) likelihood-values (Ls2') for a potential information word (s2) and furthermore likelihood-values (Lp2') for a potential first parity word (p2), using a soft-decision FEC decoding scheme that corresponds to said second FEC encoding scheme,
    - providing pre-defined likelihood-values (Lz) corresponding to said pre-defined bit-word (z),
    - deriving from said likelihood-values (Ls2') of said potential information word (s2), from said likelihood-values (Lp2') of said first potential parity word (p2) and from said pre-defined likelihood-values (Lz) adjusted likelihood-values (Ls2") at least for said potential information word (s2), using a soft-decision FEC decoding scheme that corresponds to said first FEC encoding scheme.

2. Method according to claim 1, comprising furthermore

    - deriving from said adjusted likelihood values (Ls2") of said potential information word (s2) a received information word (sf).

3. Method according to claim 1,
    wherein said steps of

    - deriving said likelihood-values (Lc2) of said potential modified code word (c2),
    - deriving said likelihood-values (Ls2') of said potential information word (s2) and said likelihood-values (Lp2') of said potential first parity word (p2),
    - providing said pre-defined likelihood-values (Lz), and
    - deriving said adjusted likelihood-values (Ls2") for said potential information word (s2), are carried out in a first iterations step,

    wherein said first iteration step comprises furthermore

    - deriving from said likelihood-values (Ls2') of said potential information word (s2), from said likelihood-values (Lp2') of said potential first parity word (p2) and from said pre-defined likelihood-values (Lz) adjusted likelihood-values (Lp2") for said potential first parity word (p2), using said soft-decision FEC decoding scheme that corresponds to said first FEC encoding scheme, and
    - deriving from said likelihood-values (Lc2) of said potential modified code word (c2) likelihood-values (Ld2') for a potential second parity word (d2), using said soft-decision FEC decoding scheme that corresponds to said second FEC encoding scheme,
    comprising furthermore, in a second iteration step,
    - deriving updated likelihood-values (Lc2") for said potential modified code word (c2), using said transmitted optical signal (OS'), said adjusted likelihood-values (Ls2") of said potential information word (s2), said adjusted likelihood-values (Lp2") of said potential parity word (p2) and said likelihood values (Ld2') of said potential second parity word (d2),
    - deriving from said updated likelihood-values (Lc2") of said potential modified code word (c2) updated likelihood-values (Ls2''') of said potential information word (s2) and updated likelihood-values (Lp2''') of said potential parity word (p2), using said soft-decision FEC decoding scheme corresponding to said second FEC encoding scheme,

- providing said pre-defined likelihood-values (Lz),
- deriving from said updated likelihood-values (Ls2''') of said potential information word (s2), from said updated likelihood-values (Lp2''') of said potential parity word (p) and from said pre-defined likelihood-values (Lz) further adjusted likelihood-values (Ls2*) at least for said potential information word (s2), using said soft-decision FEC decoding scheme corresponding to said first FEC encoding scheme,
- deriving said received information word (sf) from said further adjusted likelihood values (Ls2*) of said potential information word (s2).

4. Method according to any of the claims 1 to 3,
wherein the size of said information word (s), the size of said pre-defined bit-word (z) and the size of said second parity word are selectable in dependence on a pre-defined information data rate and a predefined overall data rate.

5. Method according to claim 1,
wherein said steps of

- deriving said likelihood-values (Ls2') for said potential information word (s2) and said likelihood-values (Lp2') for said potential parity word (p2),
- providing said pre-defined likelihood-values (Lz), and
- deriving said adjusted likelihood-values (Ls2'') for said potential information word (s2), are carried out in a combined FEC decoding scheme, which accounts for said first and said second soft-decision FEC decoding scheme.

6. Method according to any of the claims 1 to 5,
wherein said first FEC encoding scheme is a systematic Low-Density-Parity-Check Coding scheme.

7. Method according to any of the claims 1 to 5,
wherein said first FEC encoding scheme is a systematic Turbo Coding scheme.

8. Method according to any of the claims 1 to 7,
wherein said second FEC encoding scheme is a Parity-Check Coding scheme.

9. Method according to any of the claims 1 to 7,
wherein said second FEC encoding scheme is a Repetition Coding scheme.

10. Method according to claim 1,
wherein said step of deriving said second parity word (d) includes furthermore an accumulation step,
and wherein said step of deriving said likelihood-values (Ls2') of said potential information word (s2) and said likelihood-values (Lp2') of said potential parity word (p), using said first soft-decision FEC decoding scheme, accounts for said accumulation step.

11. Method according to claim 1,
wherein said step of transmitting said modified systematic code word (c1), using said phase-modulated optical signal, includes a sub-step of encoding said modified systematic code word (c1) using a differential encoding scheme, and wherein said step of deriving from said transmitted optical signal said likelihood-values (Lc2) of said potential modified code word (c2) accounts for said differential encoding scheme.

12. Optical data transmitter, operable to

- concatenate a provided information word (s) and a pre-defined bit-word (z), yielding an extended information word (e),
- derive a code word (c), by FEC encoding said extended information word (e) using a first systematic FEC encoding scheme, such that said code word (c) comprises said provided information word (s), said pre-defined bit-word (z) and a first parity word (p),
- derive a modified code word (c1), by FEC encoding said information word (s) and said first parity word (p), using a second systematic FEC encoding scheme, such that said modified code word (c1) comprises said information word (s), a second parity word (d) and said first parity word (p),
- transmit said modified code word (c1), using a phase-modulated optical signal (OS).

**13.** Optical data receiver, operable to

- derive from a transmitted optical signal (OS') likelihood-values (Lc2) for a potential code word (c2),
- derive from said likelihood-values (Lc2) of said potential code word (c2) likelihood-values (Ls2') for a potential information word (s2) and furthermore likelihood-values (Lp2') for a potential parity word (p2), using a first pre-selected soft-decision FEC decoding scheme,
- provide pre-defined likelihood-values (Lz),
- derive from said likelihood-values (Ls2') of said potential information word (s2), from said likelihood-values (Lp2') of said potential parity word (p2) and from said pre-defined likelihood-values (Lz) adjusted likelihood-values (Ls2") for said potential information word (s2), using a second pre-selected soft-decision FEC decoding scheme.

**14.** Data encoder for an optical data transmitter, operable to

- concatenate a provided information word (s) and a pre-defined bit-word (z), yielding an extended information word (e),
- derive a code word (c), by FEC encoding said extended information word (e) using a first systematic FEC encoding scheme, such that said code word (c) comprises said provided information word (s), said pre-defined bit-word (z) and a first parity word (p),
- derive a modified code word (c1), by FEC encoding said information word (s) and said first parity word (p), using a second systematic FEC encoding scheme, such that said modified code word (c1) comprises said information word (s), a second parity word (d) and said first parity word (p),
- and provide said modified code word (c1) to an optical phase-modulation device.

**15.** Data decoder for an optical data receiver, operable to

- derive from provided phase-values and/or amplitude-values likelihood-values (Lc2) of a potential code word (c2),
- derive from said likelihood-values (Lc2) of said potential code word (c2) likelihood-values (Ls2') for a potential information word (s2) and furthermore likelihood-values (Lp2') for a potential parity word (p2), using a first pre-selected soft-decision FEC decoding scheme,
- provide pre-defined likelihood-values (Lz),
- derive from said likelihood-values (Ls2') of said potential information word (s2), from said likelihood-values (Lp2') of said potential parity word (p2) and from said pre-defined likelihood-values (Lz) adjusted likelihood-values (Ls2") for said potential information word (s2), using a second pre-selected soft-decision FEC decoding scheme.

**16.** Optical data transmission system,
comprising an optical data transmitter according to claim 12 and an optical data receiver according to claim 13.

## Fig. 1a

## Fig. 1b

**Fig. 2**

TXS

MAS

CS

C1 → [ IQ-Mapping ] → MD → [ Modulate ] → OS

MOS

**Fig. 3**

Ls2" → [ HD ] → sf

**Fig. 4a**

u → [ FECA ] → [ IL ] → s

**Fig. 4b**

sf → [ DIL ] → [ DFECA ] → uf

## Fig. 5

**Fig. 6**

EP 2 747 292 A1

Fig. 7

$$\overleftarrow{Ld2_1'}$$

$$\overrightarrow{Ld2_1}$$

$$\overrightarrow{Ls2_1}$$

$$\overrightarrow{Ls2_1'}$$

$$\overleftarrow{Ls2_1''}$$

$$\overleftarrow{Ls2_1'}$$

IN1

Fig. 8

**Fig. 9**

**Fig. 10**

# Fig. 11

**Fig. 12a**

EP 2 747 292 A1

# Fig. 12b

$$d_i' \longrightarrow \boxed{+} \longrightarrow d_i$$

$$\boxed{z^{-1}}$$

Fig. 13

Extended LDPC code

CSDDEC3

IQD'

EP 2 747 292 A1

**Fig. 14**

Extended LDPC code

EP 2 747 292 A1

Fig. 15

EP 2 747 292 A1

# Fig. 16

# Fig. 17

EP 2 747 292 A1

Europäisches
Patentamt

European
Patent Office

Office européen
des brevets

# EUROPEAN SEARCH REPORT

Application Number

EP 12 30 6652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 320 574 A2 (BROADCOM CORP [US]) 11 May 2011 (2011-05-11) * abstract; figure 1 * * paragraph [0046] * * paragraph [0048]; figure 2 * * paragraph [0071] * * paragraph [0076] - paragraph [0077] * * paragraph [0082] - paragraph [0090]; figures 6, 7, 10 * | 1-4,6-9, 11-16 | INV. H03M13/29 H03M13/11 H03M13/37 |
| X | IVAN B DJORDJEVIC ET AL: "Reverse Concatenated Coded Modulation for High-Speed Optical Communication", IEEE PHOTONICS JOURNAL, IEEE, USA, vol. 2, no. 6, December 2010 (2010-12), pages 1034-1039, XP011485027, ISSN: 1943-0655, DOI: 10.1109/JPHOT.2010.2091678 * abstract * * page 1037, paragraph 1 * * page 1038 * | 1-4,6-9, 11-16 | |
| A | US 2010/077276 A1 (OKAMURA SHUTAI [JP] ET AL) 25 March 2010 (2010-03-25) * paragraph [0110] - paragraph [0111] * * paragraph [0115] - paragraph [0127]; figures 10, 11 * * paragraph [0225] * * paragraph [0231] - paragraph [0232]; figures 31, 33 * | 1-16 | TECHNICAL FIELDS SEARCHED (IPC) H03M |

-/--

The present search report has been drawn up for all claims

| Place of search | Date of completion of the search | Examiner |
|---|---|---|
| Munich | 12 September 2013 | Farman, Thomas |

EPO FORM 1503 03.82 (P04C01)

Europäisches
Patentamt

European
Patent Office

Office européen
des brevets

**EUROPEAN SEARCH REPORT**

Application Number

EP 12 30 6652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DAMIAN A MORERO ET AL: "Efficient concatenated coding schemes for error floor reduction of LDPC and turbo product codes", GLOBAL COMMUNICATIONS CONFERENCE (GLOBECOM), 2012 IEEE, IEEE, 3 December 2012 (2012-12-03), pages 2361-2366, XP032375026, DOI: 10.1109/GLOCOM.2012.6503469 ISBN: 978-1-4673-0920-2 * the whole document * | 1-16 | |
| X | MICHAEL LENTMAIER ET AL: "From product codes to structured generalized LDPC codes", 5TH INTERNATIONAL ICST CONFERENCE ON COMMUNICATIONS AND NETWORKING IN CHINA (CHINACOM), IEEE, PISCATAWAY, NJ, USA, 25 August 2010 (2010-08-25), pages 1-8, XP031847070, ISBN: 978-0-9845893-3-3 * first page, section "II. PRODUCT CODES", sub-section "A. Code Structure", and footnote 1 * * fourth page, sentence bridging the right-hand and left-hand columns. * * Section IV, sub-section "B. Iterative Decoding of GLDPC Codes", first paragraph. * | 5,10 | |

-/--

TECHNICAL FIELDS
SEARCHED     (IPC)

The present search report has been drawn up for all claims

| Place of search | Date of completion of the search | Examiner |
|---|---|---|
| Munich | 12 September 2013 | Farman, Thomas |

EPO FORM 1503 03.82 (P04C01)

Europäisches
Patentamt

European
Patent Office

Office européen
des brevets

# EUROPEAN SEARCH REPORT

Application Number

EP 12 30 6652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NARAYANAN K ET AL: "Design of serial concatenated msk schemes based on density evolution", IEEE TRANSACTIONS ON COMMUNICATIONS, IEEE SERVICE CENTER, PISCATAWAY, NJ. USA, vol. 51, no. 8, August 2003 (2003-08), pages 1283-1295, XP011099951, ISSN: 0090-6778, DOI: 10.1109/TCOMM.2003.815076 * Section II, Figure 1 * * Section V., Figures 10, 11 * ----- | 1,5,10 | |
| A | JIANRONG BAO ET AL: "Concatenated eIRA Codes for Tamed Frequency Modulation", IEEE INTERNATIONAL CONFERENCE ON COMMUNICATIONS, 2008 : ICC '08 ; 19 - 23 MAY 2008, BEIJING, CHINA, IEEE, PISCATAWAY, NJ, USA, 19 May 2008 (2008-05-19), pages 1886-1891, XP031265683, ISBN: 978-1-4244-2075-9 * the whole document * ----- | 1,11 | TECHNICAL FIELDS SEARCHED (IPC) |

The present search report has been drawn up for all claims

| Place of search | Date of completion of the search | Examiner |
|---|---|---|
| Munich | 12 September 2013 | Farman, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

Application Number

EP 12 30 6652

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

**Application Number**

EP 12 30 6652

The Search Division considers that the present European patent application does not comply with the requirements of unity of invention and relates to several inventions or groups of inventions, namely:

1. claims: 1-4, 6-9, 11-16

     Claim 3 concerns iterative decoding of the concatenated coding scheme of claim 1. Claims 1, 2, 4-9 and 11-16 do not concern iterative decoding but are formally included in the first invention because they can be searched and examined together with the first invention.
     ---

2. claims: 5, 10

     These claims concern the use of a combined decoding scheme and/or the inclusion of an accumulation step.
     ---

## ANNEX TO THE EUROPEAN SEARCH REPORT
## ON EUROPEAN PATENT APPLICATION NO.

EP 12 30 6652

This annex lists the patent family members relating to the patent documents cited in the above-mentioned European search report.
The members are as contained in the European Patent Office EDP file on
The European Patent Office is in no way liable for these particulars which are merely given for the purpose of information.

12-09-2013

| Patent document cited in search report | | Publication date | Patent family member(s) | | Publication date |
|---|---|---|---|---|---|
| EP 2320574 | A2 | 11-05-2011 | CN 101997645 A | | 30-03-2011 |
| | | | EP 2320574 A2 | | 11-05-2011 |
| US 2010077276 | A1 | 25-03-2010 | CN 101632249 A | | 20-01-2010 |
| | | | JP 2008228285 A | | 25-09-2008 |
| | | | US 2010077276 A1 | | 25-03-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 11160751 A

**Non-patent literature cited in the description**

- **TEN BRINK, S. ; SPEIDEL, J. ; RAN-HONG YAN.** Iterative demapping and decoding for multilevel modulation. *Global Telecommunications Conference,* 1998, vol. 1, 579-584
- **KOETTER, R. ; SINGER, A.C. ; TÜCHLER, M.** *Turbo Equalization, Signal Processing Magazine, IEEE,* January 2004, vol. 21 (1), 67-80
- **FRANK R. KSCHISCHANG ; BRENDAN J. FREY ; HANS-ANDREA LOELIGER.** Factor graphs and the sum-product algorithm. *IEEE TRANSACTIONS ON INFORMATION THEORY,* February 2001, vol. 47 (2
- **J. HAGENAUER ; E. OFFER ; L. PAPKE.** Iterative Decoding of Binary Block and Convolutional Codes. *IEEE TRANSACTIONS ON INFORMATION THEORY,* March 1996, vol. 42 (2